# EUROPEAN PATENT APPLICATION

(11) **EP 2 835 835 A1**
(43) Date of publication of application: **11.02.2015**
(21) Application number: 13773127.9
(22) Date of filing: 29.03.2013
(51) Int. Cl.: H01L 31/04, H01L 31/042

(54) **CRYSTAL SYSTEM SOLAR BATTERY MODULE AND METHOD FOR MANUFACTURING SAME**

(30) Priority: 06.04.2012 JP 2012087832
(71) Applicant: Dexerials Corporation, Tokyo 141-0032 (JP)
(72) Inventor: OKUMIYA, Hideaki, Kanuma-shi Tochigi 322-8503 (JP); SUGA, Yasuhiro, Kanuma-shi Tochigi 322-8503 (JP); HIGUCHI, Akifumi, Kanuma-shi Tochigi 322-8503 (JP); FUJII, Takahiro, Kanuma-shi Tochigi 322-8503 (JP)
(74) Representative: Hill, Christopher Michael
(86) International application number: PCT/JP2013/059553
(87) International publication number: WO 2013/150976

(57) **Abstract**

A crystalline solar battery module, which includes: tab wires each containing an electrically conductive layer; and crystalline solar cells each containing finger electrode, wherein the electrically conductive layer and the finger electrodes are electrically connected with an electrically conductive adhesive, wherein the crystalline solar cell has a busbar-less structure, in which no busbar electrode is present, wherein the crystalline solar cell contains fillet forming electrodes, where the fillet forming electrodes are each formed to be at least partially in contact with or to be apart from side surfaces of the tab wires in connection regions, in each of which the crystalline solar cell and the tab wire are connected with the electrically conductive adhesive, and wherein the electrically conductive adhesive forms fillets at least at part of the side surfaces of the tab wires.

## Description

### Technical Field

The present invention relates to a crystalline solar battery module, and a production method thereof.

### Background Art

A solar battery is clean, and directly converts unlimitedly supplied sun light into electricity. Therefore, the solar battery is attracted attention as a new energy source.

The solar battery uses a plurality of solar cells connected with a tab wire, as a solar battery module.

As for a conventional tab wire, a type of a tab wire, in which a solder is applied on a surface of a copper wire, has been used. As high temperature is required for solder connection, however, a crack or warp of a panel on a light-receiving surface is caused, or a short circuit is caused due to the solder bled (leaked) from the tab wire, which becomes a cause of a problem.

Therefore, an electrically conductive adhesive has been used as a connection material replacing a solder. Since the electrically conductive adhesive achieves connection at low temperature, problems, such as a warp of a solar cell, and crack thereof, can be reduced.

Typically, the solar cell takes out electric energy obtained by converting solar energy, and therefore the solar cell contains finger electrodes and busbar electrodes. The finger electrode is an electrode for collecting electricity generated in the solar cell. The busbar electrode is an electrode for collecting electricity from the finger electrode. In the solar battery module, the tab wire and the busbar electrodes were electrically connected. Therefore, the electricity generated in the solar cell is collected by the tab wire via the finger electrodes and the busbar electrodes.

The busbar electrodes are typically formed by applying a solver paste. It is possible to reduce a cost of the solar cell by reducing the silver paste for use. Therefore, a solar cell and a solar battery module of so-called a busbar-less structure where no busbar electrode is used have recently been developed. Especially, a solar battery module, in which the electrically conductive adhesive is used for connection between the solar cells and the tab wire, can be produced by efficiently connecting solar cells of a busbar-less structure. Therefore, such a solar battery module has attracted an attention

However, a solar battery module, in which a tab wire and finger electrodes of solar cells are electrically connected via an electrically conductive adhesive, and which uses solar cells of a busbar-less structure, has a problems that connection reliability of the solar battery module, especially a crystalline solar battery module, and adhesion between the tab wire and the solar cells are insufficient, as fixation of the tab wire to the solar cells is not sufficient.

Associated with a structure of a connection region between the tab wire and the solar cell, proposed is to provide a supporting electrode adjacent to the connection region (for example, see PTL 1).

In this proposed technology, however, the supporting electrode is used exclusively for realizing a collection of electric currents even when the finger electrodes are disconnected (see the paragraphs [0016] to [0019] of PTL 1). Use of this proposed technology does not solve the aforementioned problems.

Accordingly, there is currently a need for providing a crystalline solar battery module using crystalline solar cells of a busbar-less structure, which has excellent connection reliability and adhesion between a tab wire and the crystalline solar cells, and a production method thereof.

### Citation List

### Patent Literature

PTL 1: Japanese Patent Application Laid-Open (JP-A) No. 2010-239167

### Summary of Invention

### Technical Problem

The present invention aims to solve the aforementioned various problems in the art, and achieve the following object. An object of the present invention is to provide a crystalline solar battery module, which uses crystalline solar cells of a busbar-less structure, and has excellent connection reliability and adhesion between a tab wire and the crystalline solar cells, and to provide a production method of the crystalline solar battery module.

### Solution to Problem

The means for solving the aforementioned problems are as follows:
<1> A crystalline solar battery module, containing:
   tab wires each containing an electrically conductive layer; and
   crystalline solar cells each containing finger electrode,
   wherein the electrically conductive layer and the finger electrodes are electrically connected with an electrically conductive adhesive,
   wherein the crystalline solar cell has a busbar-less structure, in which no busbar electrode is present,
   wherein the crystalline solar cell contains fillet forming electrodes, where the fillet forming electrodes are each formed to be at least partially in contact with or to be apart from side surfaces of the tab wires in connection regions, in each of which the crystalline solar cell and the tab wire are connected with the electrically conductive adhesive, and
   wherein the electrically conductive adhesive forms fillets at least at part of the side surfaces of the tab wires.
<2> The crystalline solar battery module according to <1>, wherein an average height of the fillet forming electrodes is equal to or greater than an average thickness of the electrically conductive layer.
<3> The crystalline solar battery module according to <1> or <2>, wherein an average distance between the tab wire and the fillet forming electrode is 0 mm to 0.30 mm.
<4> The crystalline solar battery module according to any one of <1> to <3>, wherein an average thickness of the electrically conductive layer of the tab wire is 5 µm to 20 µm.
<5> The crystalline solar battery module according to any one of <1> to <4>, wherein an average height of the fillet forming electrodes is 10 µm to 60 µm.
<6> The crystalline solar battery module according to any one of <1> to <5>, wherein the tab wire has a wavy shape.
<7> A production method of a crystalline solar battery module, containing:
   applying an electrically conductive adhesive onto light-receiving surfaces of a plurality of crystalline solar cells as well as opposite surfaces thereof to the light-receiving surfaces, arranging tab wires each containing an electrically conductive layer on the electrically conductive adhesive, and heating and pressing the tab wires, to thereby produce a string, in which finger electrodes of the crystalline solar cells are electrically connected with the tab wires with the electrically conductive adhesive, and the crystalline solar cells are connected in series;
   covering the string with a sealing resin, and covering the sealing resin with a moisture barrier back sheet or a glass plate;
   pressing the moisture barrier back sheet or the glass plate; and
   heating a heating stage on which the string is placed,
   wherein the crystalline solar cell has a busbar-less structure, in which no busbar electrode is present, and
   wherein the arranging contains arranging the crystalline solar cells, the electrically conductive adhesive, and the tab wires in a manner that fillet forming electrodes of the crystalline solar cell are each at least partially in contact with or apart from side surfaces of the tab wires.
<8> The production method according to <7>, wherein an average height of the fillet forming electrodes is equal to or greater than an average thickness of the electrically conductive layer.

### Advantageous Effects of the Invention

The present invention can solve the aforementioned various problems in the art, achieve the aforementioned object, and provide a crystalline solar battery module, which uses crystalline solar cells of a busbar-less structure, and has excellent connection reliability and adhesion between a tab wire and the crystalline solar cells, and a production method of the crystalline solar battery module.

### Brief Description of Drawings

FIG. 1 is a schematic top view illustrating one example of a crystalline solar cell for use in the crystalline solar battery module of the present invention.
FIG. 2 is a schematic top view illustrating another example of a crystalline solar cell for use in the crystalline solar battery module of the present invention.
FIG. 3 is a schematic cross-sectional view for explaining a positional relationship between a fillet forming electrode and a tab wire.
FIG. 4A is a schematic cross-sectional view illustrating one example of a forming state of a fillet in a connection region.
FIG. 4B is a schematic cross-sectional view illustrating another example of a forming state of a fillet in a connection region.
FIG. 5 is a disassembled perspective view illustrating one example of the crystalline solar battery module of the present invention.
FIG. 6 is a schematic diagram illustrating one example of the crystalline solar battery module of the present invention.
FIG. 7 is a schematic top view illustrating the crystalline solar cell model of Example 1.

### Description of Embodiments

### (Crystalline solar Battery Module)

The crystalline solar battery module of the present invention contains at least crystalline solar cells, tab wires, and an electrically conductive adhesive, and may further contain other members, such as a sealing resin, a moisture barrier back sheet, and a glass plate, according to the necessity.

The crystalline solar battery module is a solar battery module, in which an electrically conductive layer of the tab wire and finger electrodes of the crystalline solar cell are electrically connected with the electrically conductive adhesive.

### <Crystalline solar Cell>

The crystalline solar cell contains a photoelectric conversion element as a photoelectric conversion unit, finger electrodes, and fillet forming electrodes, and may further contain other members according to the necessity.

The crystal photoelectric conversion element is appropriately selected depending on the intended purpose without any limitation, provided that the crystal photoelectric conversion element is a photoelectric conversion element containing a crystal photoelectric conversion material.

Examples of the crystal photoelectric conversion material include monocrystalline silicon, polycrystalline silicon, a monocrystalline compound (e.g., GaAs), and a polycrystalline compound (e.g., CdS, and CdTe).

The crystalline solar cell has a busbar-less structure, in no busbar electrode is present.

The crystalline solar cell may contain supporting electrodes, each of which is provided orthogonal to the finger electrode, and which are configured to electrically connect a plurality of the finger electrodes to each other. Note that, the supporting electrode is different from the busbar electrode.

### -Finger Electrode-

The finger electrode is an electrode configured to collect electricity generated in the photoelectric conversion unit. In the crystalline solar cell, the finger electrodes are formed to be substantially orthogonal to the tab wire.

A material of the finger electrode is appropriately selected depending on the intended purpose without any limitation, and examples thereof include silver, gold, copper, tin, and nickel.

The average width of the finger electrodes is appropriately selected depending on the intended purpose without any limitation, but the average width thereof is preferably 20 µm to 200 µm, more preferably 20 µm to 100 µm.

The average width can be determined, for example, by measuring the width of the dinger electrode at arbitrary selected 10 points on the finger electrode, and calculating an average of the measured values.

A formation method of the finger electrodes is appropriately selected depending on the intended purpose without any limitation. For example, the finger electrodes can be formed by printing a silver paste on the crystalline solar cell to give a desired pattern of the finger electrodes. Examples of the printing method include screen printing.

### -Fillet Forming Electrode-

The fillet forming electrodes are formed on the crystalline solar cell in a manner that each fillet forming electrode is at least partially in contact with, or is apart from side surfaces of the tab wire in the connection region where the crystalline solar cell and the tab wire are connected with the electrically conductive adhesive.

The fillet forming electrode is an electrode for forming a fillet with the electrically conductive adhesive of the connection region.

For example, the fillet forming electrode is substantially orthogonal to the finger electrode.

A material of the fillet forming electrodes is appropriately selected depending on the intended purpose without any limitation, and examples thereof include silver, gold, copper, tin, and nickel.

The average width of the fillet forming electrodes is appropriately selected depending on the intended purpose without any limitation, but the average width thereof is preferably 20 µm to 200 µm, more preferably 20 µm to 150 µm.

The average width can be determined, for example, by measuring the width of the fillet forming electrode at arbitrary selected 10 points on the fillet forming electrode, and calculating an average of the measured values.

The average height of the fillet forming electrodes is preferably 5 µm to 70 µm, more preferably 10 µm to 60 µm.

The average height can be determined, for example, by measuring the height of the fillet forming electrode at arbitrary selected 10 points on the fillet forming electrode, and calculating an average of the measured values.

The average height (H) of the fillet forming electrodes is appropriately selected depending on the intended purpose without any limitation, but the average height (H) is preferably equal to or higher than the average thickness (T) of the electrically conductive layer of the tab wire. A difference (H-T) between the average height (H) and the average thickness (T) is more preferably 0 µm to 50 µm, particularly preferably 5 µm to 40 µm.

When the average height (H) of the fillet forming electrodes is less than the average thickness (T) of the electrically conductive layer of the tab wire, a fillet is formed insufficiently, and therefore the pealing strength becomes low.

A formation method of the fillet forming electrodes is appropriately selected depending on the intended purpose without any limitation. For example, the fillet forming electrodes can be formed by printing a silver paste on the crystalline solar cell to give a desired pattern of the fillet forming electrodes. Examples of the printing method include screen printing.

The fillet forming electrodes and the finger electrodes may be formed at the same time. The fillet forming electrodes and the finger electrodes can be formed at the same time, for example, by screen printing a silver paste using a printing board in the pattern capable of forming desired fillet forming electrodes and desired finger electrodes.

The average thickness of the crystalline solar cell is appropriately selected depending on the intended purpose without any limitation.

The crystalline solar cell is explained with reference to the drawings.

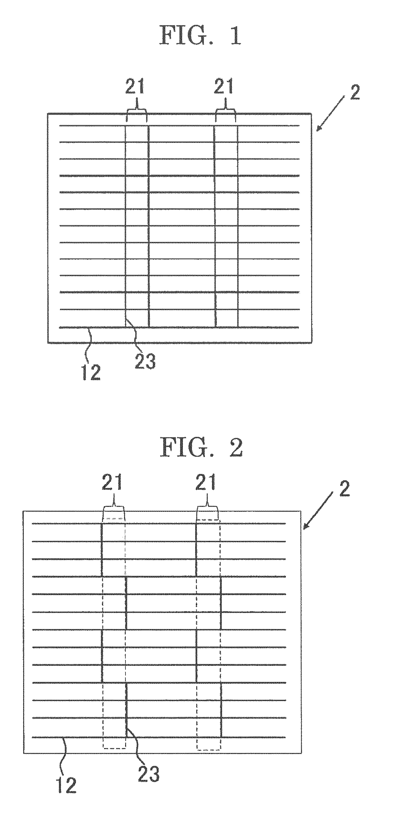

FIG. 1 is a schematic top view illustrating one example of the crystalline solar cell. The crystalline solar cell 2 illustrated in FIG. 1 is a crystalline solar cell of a busbar-less structure, and has a structure where finger electrodes 12 and fillet forming electrodes 23 are formed on a crystalline photoelectric conversion element. The finger electrode 12 is an electrode configured to collect electricity generated by the crystalline photoelectric conversion element. The fillet forming electrodes 23 are formed along both eches of the connection regions 21 in the substantially orthogonal direction to the finger electrodes 12.

Next, FIG. 2 is a schematic top view illustrating another example of the crystalline solar cell. The crystalline solar cell 2 illustrated in FIG. 2 is a crystalline solar cell of a busbar-less structure, and has a structure where finger electrodes 12 and fillet forming electrodes 23 are formed on a crystalline photoelectric conversion element. The fillet forming electrodes 23 are formed at the both edges of the connection regions 21, which are represented with dashed lines, in the substantially orthogonal direction to the finger electrodes 12. Each fillet forming electrode 23 is formed to cross over four finger electrodes 12, and is formed in the form of short dashed lines, without being continuously, at one end of the connection region 21.

### <Tab Wire>

The tab wire is appropriately selected depending on the intended purpose without any limitation, provided that the tab wire contains an electrically conductive layer, and is a wire configured to electrically connect between the crystalline solar cells adjacent to each other.

A structure of the tab wire is appropriately selected depending on the intended purpose without any limitation, and examples thereof include a structure containing a substrate, and the electrically conductive layer.

A material of the substrate is appropriately selected depending on the intended purpose without any limitation, and examples thereof include copper, aluminum, iron, gold, silver, nickel, palladium, chromium, molybdenum, and an alloy thereof.

The electrically conductive layer is appropriately selected depending on the intended purpose without any limitation, and examples thereof include an electrically conductive layer formed by gold plating, silver plating, tin plating, or solder plating.

The average thickness of the electrically conductive layer is appropriately selected depending on the intended purpose without any limitation, provided that the average thickness thereof is equal to or shorter than the average height (H) of the fillet forming electrode. The average thickness of the electrically conductive layer is preferably 5 µm to 20 µm.

The average thickness can be determined, for example, by measuring the thickness of the electrically conductive layer at arbitrary selected 10 points on the electrically conductive layer, and calculating an average of the measured values.

A shape of the tab wire is appropriately selected depending on the intended purpose without any limitation, but a cross-section thereof, which is cut in the longer direction of the tab wire, and is orthogonal to a light-receiving surface of the crystalline solar cell, is preferably a wavy shape. When the crystalline solar battery module is produced, the tab wires are pushed towards the crystalline solar cell. As there are parts where the finger electrode is present and parts where the finger electrode is not present, a shape of each tab wire becomes a wavy shape. As a result of this, fillets are more certainly formed.

The average width of the tab wire is appropriately selected depending on the intended purpose without any limitation, but the average width thereof is preferably 0.5 mm to 3 mm.

The average thickness of the tab wire is appropriately selected depending on the intended purpose without any limitation, but the average thickness thereof is preferably 5 µm to 300 µm.

A production method of the tab wire is appropriately selected depending on the intended purpose without any limitation. Examples thereof include: a method containing slitting a copper foil with a solder plating layer, in which the solder plating layer having the average thickness of 5 µm to 20 µm is provided to the copper foil rolled into the average thickness of 5 µm to 300 µm, into the average width of 0.5 mm to 3 mm; and a method containing rolling a thin metal wire, such as copper, into a plate having the average width of 0.5 mm to 3 mm, followed by solder plating the plate.

The average distance between the tab wire and the fillet forming electrode is appropriately selected depending on the intended purpose without any limitation, but the average distance is preferably 0 mm to 0.30 mm, more preferably 0 mm to 0.20 mm. When the average distance is within the aforementioned more preferable range, it is advantageous in view of an excellent fillet formation state.

The average distance can be determined, for example, measuring the distance between the tab wire and the fillet forming electrode at arbitrary selected 10 points, and calculating an average of the measured values.

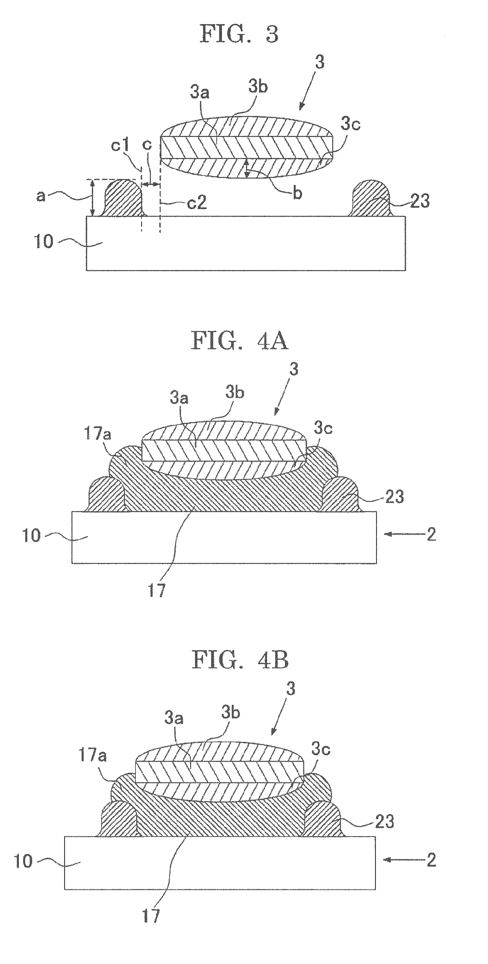

As illustrated in FIG. 3, the distance between the tab wire and the fillet forming electrode means a distance "c" between the edge (a center part in the height direction of the edge is used as a standard of the edge) of the fillet forming electrode 23 and the edge of the tab wire 3. In FIG. 3, the reference number 10 denotes a crystalline photoelectric conversion element, the reference number 3a denotes a substrate of the tab wire, and the reference numbers 3b and 3c each denote an electrically conductive layer, and the electrically conductive layers are formed on both surfaces of the substrate 3a. More specifically, the distance "c" is a distance between the line "c1" passing through the edge of the fillet forming electrode 23 and being orthogonal to the crystalline photoelectric conversion element 10 and the line "c2" passing through the edge of the tab wire 3 and being orthogonal to the crystalline photoelectric conversion element 10.

Note that, in FIG. 3, the reference symbol "a" denotes a height of the fillet forming electrode 23, and the reference symbol "b" denotes a thickness of the electrically conductive layer 3c.

### <Electrically Conductive Adhesive>

The electrically conductive adhesive is appropriately selected depending on the intended purpose without any limitation. Examples of the electrically conductive adhesive include an electrically conductive adhesive containing at least electrically conductive particles, preferably further containing a film forming resin, a hardening resin, and a hardening agent, and optionally further containing other components according to the necessity.

### -Electrically Conductive Particles-

The electrically conductive particles are appropriately selected depending on the intended purpose without any limitation, and examples thereof include nickel particles, gold-coated nickel particles, resin particles where resin cores are coated with Ni, and resin particles where resin cores are coated with Ni, and outermost surfaces thereof are further coated with Au.

### -Film Forming Resin-

The film forming resin is appropriately selected depending on the intended purpose without any limitation, and examples thereof include a phenoxy resin, an unsaturated polyester resin, a saturated polyester resin, a urethane resin, a butadiene resin, a polyimide resin, a polyamide resin, and a polyolefin resin. These may be used alone, or in combination. Among them, a phenoxy resin is particularly preferable.

### -Hardening Resin-

The hardening resin is appropriately selected depending on the intended purpose without any limitation, and examples thereof include an epoxy resin, and an acrylate resin.

### --Epoxy Resin--

The epoxy resin is appropriately selected depending on the intended purpose without any limitation, and examples thereof include a bisphenol A epoxy resin, a bisphenol F epoxy resin, a novolak epoxy resin, a modified epoxy resin thereof, and an alicyclic epoxy resin. These may be used alone, or in combination.

### --Acrylate Resin--

The acrylate resin is appropriately selected depending on the intended purpose without any limitation, and examples thereof include methyl acrylate, ethyl acrylate, isopropyl acrylate, isobutyl acrylate, epoxy acrylate, ethylene glycol diacrylate, diethylene glycol diacrylate, trimethylol propane triacrylate, dimethylol tricyclodecane diacrylate, tetramethylene glycol tetraacrylate, 2-hydroxy-1,3-diacryloxypropane, 2,2-bis[4-(acryloxymethoxy)phenyl]propane, 2,2-bis[4-(acryloxyethoxy)phenyl]propane, dicyclopentenyl acrylate, tricyclodecanyl acrylate, tris(acryloxyethyl)isocyanurate, and urethane acrylate. These may be used alone, or in combination.

Moreover, examples thereof further include methacrylates of the aforementioned acrylate, and these may be used alone, or in combination.

### -Hardening Agent-

The hardening resin is preferably used in combination with a hardening agent. The hardening agent is appropriately selected depending on the intended purpose without any limitation, and examples thereof include: imidazole, such as 2-ethyl-4-methylimidazole; organic peroxide, such as lauryloyl peroxide, butyl peroxide, benzyl peroxide, dilauryloyl peroxide, dibutyl peroxide, peroxydicarbonate, and benzoyl peroxide; an anionic hardening agent, such as organic amine; and a cationic hardening agent, such as a sulfonium salt, an onium salt, and an aluminum chelating agent.

Among them, a combination of an epoxy resin and an imidazole-based latent hardening agent, and a combination of an acrylate resin and an organic peroxide-based hardening agent are particularly preferable.

### -Other Components-

The aforementioned other components are appropriately selected depending on the intended purpose without any limitation, and examples thereof include a silane coupling agent, filler, a softening agent, an accelerator, an antioxidant, a colorant (a pigment, a dye), an organic solvent, and an ion catcher. An amount of the aforementioned other components is appropriately selected depending on the intended purpose without any limitation.

The electrically conductive adhesive forms a fillet (fillets) at least at part of the side surfaces of the tab wire.

The fillet is part of the electrically conductive adhesive, which is protruded from the connection surface between the tab wire and the crystalline solar cell in the connection region, and pushed up to the side surfaces of the tab wire.

One example of a formation state of the fillets in the connection region is explained with reference to drawings.

FIG. 4A is a schematic cross-sectional view illustrating one example of the formation state of the fillets in the connection region. In FIG. 4A, the distance between the tab wire 3 and the fillet forming electrode 23 is greater than 0 mm. The electrically conductive adhesive 17 is protruded from the connection surface between the tab wire 3 and the crystalline solar cell 2 by heat and pressure applied during the connection for the tab wire 3 and the crystalline solar cell 2. The protruded electrically conductive adhesive 17 is dammed up by the fillet forming electrode 23, and is then pushed up to the side surfaces of the tab wire 3, to thereby form a fillet 17a.

FIG. 4B is a schematic cross-sectional view illustrating another example of the formation state of the fillet in the connection region. In FIG. 4B, the distance between the tab wire 3 and the fillet forming electrode 23 is 0 mm. The electrically conductive adhesive 17 is protruded from the connection surface between the tab wire 3 and the crystalline solar cell 2 by heat and pressure applied during the connection for the tab wire 3 and the crystalline solar cell 2. The protruded electrically conductive adhesive 17 is dammed up by the fillet forming electrode 23, and is then pushed up to the side surfaces of the tab wire 3, to thereby form a fillet 17a.

Note that, an embodiment where a fillet 17a is separated from a main body of an electrically conductive adhesive 17 is also within a scope of the present invention.

As the fillet is formed, an adhesion force to the tab wire is improved, and a crystalline solar battery module having excellent connection reliability, and adhesion between a tab wire and crystalline solar cells can be attained.

Note that, even in a case where the fillet is separated from a main body of the electrically conductive adhesive, the adhesion force to the tab wire is improved by bonding the side surfaces of the tab wire and the fillet forming electrode with the fillet.

Note that, in FIGs. 4A and 4B, the reference number 3a denotes a substrate of the tab wire, and the reference numbers 3b and 3c each denote an electrically conductive layer, and the electrically conductive layers are formed on both surfaces of the substrate 3a.

### <Sealing Resin>

The sealing resin is appropriately selected depending on the intended purpose without any limitation, and examples thereof include an ethylene-vinyl acetate copolymer (EVA), ethylene-vinyl acetate-triallyl isocyanurate (EVAT), polyvinyl butyral (PVB), polyisobutylene (PIB), a silicone resin, and a polyurethane resin.

### <Moisture Barrier Back Sheet>

The moisture barrier back sheet is appropriately selected depending on the intended purpose without any limitation, and examples thereof include polyethylene terephthalate (PET), aluminum (Al), and a laminate of PET, Al, and polyethylene (PE).

### <Glass Plate>

The glass plate is appropriately selected depending on the intended purpose without any limitation, and examples thereof include a soda lime float glass plate.

A production method of the crystalline solar battery module is appropriately selected depending on the intended purpose without any limitation, but the production method thereof is preferably the production method of a crystalline solar battery module of the present invention, which is explained later.

One example of the crystalline solar battery module of the present invention is explained with reference to drawings.

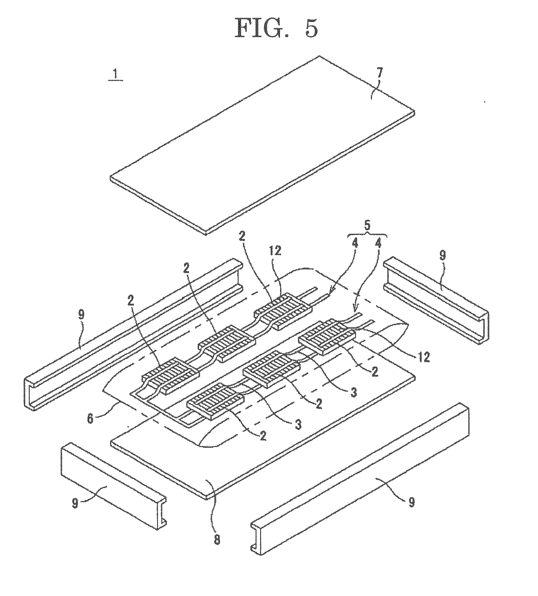

FIG. 5 is a disassembled perspective view illustrating one example of the crystalline solar battery module of the present invention. The crystalline solar battery module 1 contains strings 4, in each of which a plurality of crystalline solar cells 2 are connected in series with tab wires 3 each serving as an interconnector, and has a matrix where a plurality of the strings 4 are aligned. Then, the crystalline solar battery module 1 is formed by sandwiching the matrix 5 with sheets 6 of a sealing resin, collectively laminating together with a surface cover 7 provided at the light-receiving surface side, and a moisture barrier back sheet 8 provided at the rear face side, and finally, mounting a metal frame 9, such as aluminum, at the perimeter thereof.

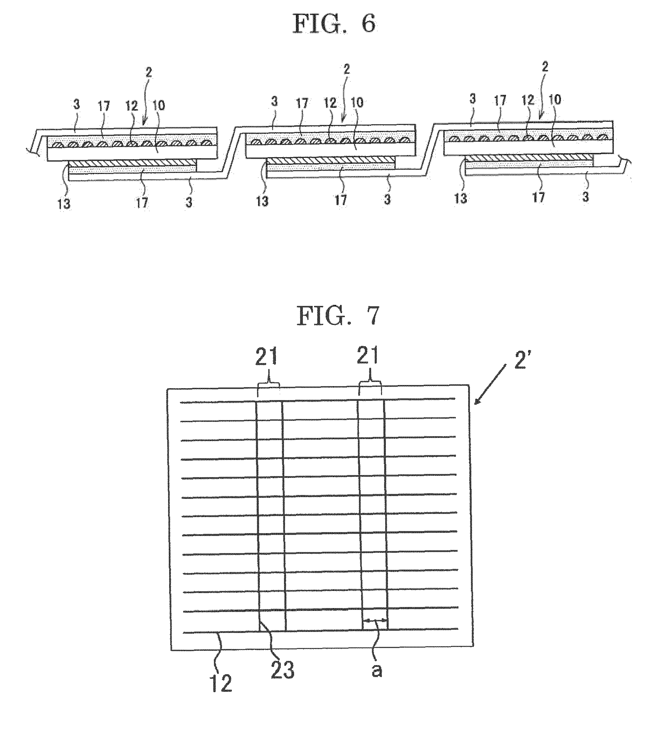

As illustrated in FIG. 6, moreover, each crystalline solar cell 2 of the crystalline solar battery module contains a crystalline photoelectric conversion element 10 formed of a silicon substrate. To the light-receiving surface of the crystalline photoelectric conversion element 10, finger electrodes 12 are provided in the direction orthogonal to the tab wire 3. Moreover, a rear face electrode 13 formed of aluminum, silver, copper, tin, or nickel is provided on a rear face of the crystalline photoelectric conversion element 10, which is opposite to the light-receiving surface thereof.

Then, a string is composed by electrically connecting finger electrodes 12 provided on a surface of the crystalline solar cell 2, and a rear face electrode 13 of the adjacent crystalline solar cell 2 with the tab wire 3 to connect the crystalline solar cells 2 in series. Connection between the tab wire 3 and the finger electrodes 12, and connection between the tab wire 3 and the rear face electrode 13 are performed with the electrically conductive adhesive 17 in the form of a film, or a paste.

### (Production Method of Crystalline Solar Battery Module)

The production method of a crystalline solar battery module of the present invention contains at least a string producing step, a covering step, a pressing step, and a heating step, and may further contain other steps according to the necessity.

The production method of a crystalline solar battery module of the present invention is suitably used for production of the crystalline solar battery module of the present invention.

### <String Producing Step>

The string producing step contains at least an applying process, an arranging process, and a heat-press process, and may further contain other processes according to the necessity.

### -Applying Process-

The applying process is appropriately selected depending on the intended purpose without any limitation, provided that it is a process containing applying an electrically conductive adhesive onto light-receiving surfaces of a plurality of crystalline solar cells as well as opposite surfaces thereof to the light-receiving surfaces.

The electrically conductive adhesive may be in the form of a film, or a paste. In the case where the electrically conductive adhesive is in the form of a film, examples of the applying process include a process containing temporarily bonding the electrically conductive adhesive in the form of a film. In the case where the electrically conductive adhesive is in the form of a paste, examples thereof include a process containing applying the electrically conductive adhesive in the form of a paste. The application method is appropriately selected depending on the intended purpose without any limitation.

In the applying process, the electrically conductive adhesive is applied to the predetermined location where the tab wire is arranged.

### --Crystalline Solar Cell--

Examples of the crystalline solar cell include those identical to the crystalline solar cell explained in the descriptions of the crystalline solar battery module of the present invention.

### --Electrically Conductive Adhesive--

The electrically conductive adhesive is appropriately selected depending on the intended purpose without any limitation.

Examples of the electrically conductive adhesive include one identical to the electrically conductive adhesive explained in the descriptions of the crystalline solar battery module of the present invention.

The average thickness of the electrically conductive adhesive is appropriately selected depending on the intended purpose without any limitation, but the average thickness thereof is preferably 3 µm to 100 µm, more preferably 5 µm to 30 µm, and particularly preferably 8 µm to 25 µm. When the average thickness thereof is less than 3 µm, an adhesive strength may be significantly low. When the average thickness thereof is greater than 100 µm, the electrically conductive adhesive may be protruded from the tab wire to thereby cause a problem in electrical connection. When the average thickness thereof is within the aforementioned particularly preferable range, it is advantageous in view of connection reliability. Note that, the average thickness is an average thickness of the electrically conductive adhesive measured before the temporarily bonding.

The average thickness is the average values of values obtained by measuring at arbitrarily selected 5 points per 20 cm².

The average width of the electrically conductive adhesive is appropriately selected depending on the intended purpose without any limitation, but the average width thereof is preferably 0.5 mm to 3 mm, as well as being equal to or shorter than the width of the tab wire.

### -Arranging Process-

The arranging process is appropriately selected depending on the intended purpose without any limitation, provided that it is a process containing arranging tab wires each containing an electrically conductive layer on the electrically conductive adhesive, sequential to the applying process.

In the arranging process, the crystalline solar cells, the electrically conductive adhesive, and the tab wires are arranged in a manner that the fillet forming electrode of the crystalline solar cell is provided to be at least partially in contact with, or be apart from side surfaces of the tab wire.

In the arranging process, moreover, a part of one tab wire is provided on a light-receiving surface of one crystalline solar cell, and another part of the tab wire is provided on a surface of another crystalline solar cell, which is opposite to a light-receiving surface thereof, between the adjacent crystalline solar cells.

### --Tab Wire--

Examples of the tab wire include one identical to the tab wire explained in the descriptions of the crystalline solar battery module of the present invention.

### -Heat-Press Process-

The heat-press process is appropriately selected depending on the intended purpose without any limitation, provided that it is a process containing heating and pressing the tab wires, sequential to the arranging process. For example, the heat-press process can be carried out by a heating tool.

The heating time, heating temperature and pressure in the heat-press process are appropriately selected depending on the intended purpose without any limitation.

In the heat-press process, it is preferred that the tab wires be each turned into a wavy shape. The wavy shape is a shape of a cross-section of the tab wire, which is cut in the longer direction of the tab wire, and is orthogonal to a light-receiving surface of the crystalline solar cell. By performing the heat-press process until the tab wire is turned into the wavy shape, fillets can be more certainly formed.

As a result of the string producing step described above, the finger electrodes of the crystalline solar cell and the tab wire are electrically connected via the electrically conductive adhesive, and a string, in which a plurality of the crystalline solar cell are connected in series, is produced.

In the production of the string, the electrically conductive adhesive forms a fillet (fillets) at least part of the side surfaces of the tab wire.

### <Covering Step>

The covering step is appropriately selected depending on the intended purpose without any limitation, provided that it is a step containing covering the string with a sealing resin, and covering the sealing resin with a moisture barrier back sheet or a glass plate.

The production method of a crystalline solar battery module as described above is preferably carried out by means of a vacuum laminator.

The sealing resin, the moisture barrier back sheet, and the glass plate are appropriately selected depending on the intended purpose without any limitation. Examples thereof include those listed as the sealing resin, the moisture barrier back sheet, and the glass plate in the descriptions of the crystalline solar battery module of the present invention.

### <Pressing Step and Heating Step>

The pressing step is appropriately selected depending on the intended purpose without any limitation, provided that it is a step containing pressing the moisture barrier back sheet or the glass plate. The pressure and time for the pressing are appropriately selected.

The heating step is appropriately selected depending on the intended purpose without any limitation, provided that it is a step containing heating a heating stage on which the string is placed. By heating the heating stage, the sealing resin can be heated.

The heating temperature in the heating step is appropriately selected depending on the intended purpose without any limitation, but the heating temperature is preferably 50°C to 250°C, more preferably 100°C to 200°C. When the heating temperature is lower than 50°C, sealing may be insufficient. When the heating temperature is higher than 250°C, organic resins, such as the electrically conductive adhesive, and the sealing resin, may be thermally decomposed. When the heating temperature is within the aforementioned more preferable range, it is advantageous in view of reliability of sealing.

The heating time in the heating step is appropriately selected depending on the intended purpose without any limitation, but the heating time is preferably 1 second to 1 hour, more preferably 5 seconds to 30 minutes, and particularly preferable 10 seconds to 20 minutes. When the heating time is shorter than 1 second, sealing may be insufficient. When the heating time is within the aforementioned particularly preferable range, it is advantageous in view of reliability of sealing.

An order for initiating the pressing step, and the heating step is appropriately selected depending on the intended purpose without any limitation.

In the manner as described above, a string where a plurality of crystalline solar cells are connected with tab wires, and the crystalline solar battery module of the present invention, in which the string is sealed, are produced.

Moreover, the crystalline solar battery module of the present invention can be also produced, for example, by forming a matrix, in which a plurality of strings are arranged, and sealing the matrix.

At the time of sealing, moreover, the crystalline solar cells and the tab wire may be electrically connected. This method can be performed, for example, by the method disclosed in JP-A No. 2010-283059.

### Examples

Examples of the present invention are explained hereinafter, but Examples shall not be construed as to limit the scope of the present invention in any way.

### (Example 1)

### <Production of Crystalline Solar Battery Module Model>

### -Tab Wire-

As a tab wire, a copper foil with a solder layer, in which the solder layer (electrically conductive layer, the average thickness: 5µm) formed of a lead-free solder was formed on one surface of the copper foil (average thickness: 150 µm), was provided. The copper foil with the solder layer was produced by rolling a copper wire into a plate of 1 mm, and plating the plate with a lead-free solder of Sn (96.5% by mass)/Ag (3% by mass)/Cu (0.5% by mass).

### -Electrically Conductive Adhesive Film-

An electrically conductive adhesive film (SP100 series, manufactured by Sony Chemical & Information Device Corporation, average thickness: 25 µm) was provided. The electrically conductive adhesive film was slit into a width of 1.0 mm for use.

### -Production of Crystalline Solar Cell Model-

As a crystalline solar cell model 2', a glass substrate, on which a pattern of finger electrodes 12 and fillet forming electrodes 23 substantially orthogonal to the finger electrodes 12, as illustrated in FIG. 7, was formed, was provided. The pattern of the finger electrodes 12 and the fillet forming electrodes 23 as illustrated in FIG. 7 was formed by screen printing a silver paste on a glass substrate (64 mm (length) × 64 mm (width) × 2.8 mm (thickness)), followed by baking. The width "a" between the fillet forming electrodes provided parallel to each other in the connection region 21 was set to 1.0 mm (average value was also 1.0 mm). The average heights of the finger electrodes 12 and the fillet forming electrodes 23 were both set to 20 µm. Moreover, the distance between the finger electrodes 12 was set to 3 mm.

The average heights of the finger electrodes and the fillet forming electrodes were each measured by measuring the height of the finger electrode or fillet forming electrode at arbitrarily selected 10 points by means of the measuring device, and calculating an average of the measured values.

### -Production of Crystalline Solar Cell Model with Tab Wires-

The electrically conductive adhesive films were temporarily bonded onto the finger electrodes 12 in the connection regions 21 of the crystalline solar cell model 2', respectively. Conditions for the temporarily bonding were the heating temperature of 70°C, the pressure of 0.5 MPa, and the duration of 1 second, and the temporarily bonding was carried out by a heating tool.

Subsequently, the tab wires were arranged on the electrically conductive adhesive films, respectively, and the tab wires were heated and pressure via a silicon rubber buffer material (average thickness: 200 µm) by means of the heating tool for 15 seconds at the press force of 2 MPa, and the heating temperature of 180°C, to thereby electrically connect the finger electrodes with the tab wires via the electrically conductive adhesive film. In the manner as described above, a crystalline solar cell model with tab wires was obtained.

### -Production of Crystalline Solar Battery Module Model-

The obtained crystalline solar cell model with the tab wires was covered with a sealing resin, and the sealing resin was covered with a moisture barrier back sheet. A 500 µm-thick ethylene-vinyl acetate copolymer was used as the sealing resin. A PET film was used as the back sheet.

Then, the resultant was sealed with the sealing resin by means of a laminator. Specifically, laminating was performed by vacuuming for 5 minutes at 100°C, followed by pressing for 5 minutes at 0.1 MPa, and thereafter, the sealing resin was cured in an oven for 45 minutes at 155°C.

In the manner as described above, a crystalline solar battery module model was obtained.

### <Evaluation>

The crystalline solar battery module model obtained above was provided to the following evaluations. The results are presented in Table 1.

### -Pealing Strength-

A pealing strength was evaluated using the crystalline solar cell model with the tab wire.

A 90° pealing test (JIS K6854-1), in which the tab wire was peeled in the direction that was 90° from the crystalline solar cell model, was performed, to thereby measure a pealing strength (N/mm). The measurement was carried out by means of a peal strength tester (Tensilon, manufactured by Orientec Co., Ltd.) at a testing speed of 50 cm/min.

### -Fillet Formation State-

A fillet formation state was confirmed by observing a cross-section of the bonding area of the tab wire and the crystalline solar cell model under a metallurgical microscope (MX50, manufactured by OLYMPUS CORPORATION). The fillet formation state was evaluated based on the following criteria.

### [Criteria]

A: A fillet was formed by sufficiently pushing the electrically conductive adhesive up to the side surfaces of the tab wire, and it was sufficiently an acceptable level.

B: A fillet was formed by slightly pushing the electrically conductive adhesive up to the side surfaces of the tab wire, and it was an acceptable level.

C: A fillet was not formed, as the electrically conductive adhesive was not pushed up to the side surfaces of the tab wire, and it was an unacceptable level.

### -Over-All Judgment-

The pealing strength and the fillet formation state were evaluated based on the following criteria.

### [Criteria]

A: The pealing strength was 1.7 N/mm or greater, and the fillet formation state was "A."
B: Satisfying condition (1) and/or condition (2), where
   the condition (1) is that the results were not applicable for the following "C", and the pealing strength was 1.6 N/mm or grater but less than 1.7 N/mm, and
   the condition (2) is that the fillet formation state was "B."
C: The pealing strength was less than 1.6 N/mm, and/or the fillet formation state was "C."

### -Connection Reliability-

An ohmic value between two tab wires in the obtained crystalline solar battery module was measured.

An initial ohmic value, and an ohmic value after a thermal cycle test (TCT, 400 cycles between -40°C and 85°C) were measured by means of a digital multimeter (Digital Multimeter 7555, manufactured by Yokogawa Electric Corporation), and a rise in value (ΔR) of the ohmic value after TCT was evaluated as connection reliability based on the following evaluation criteria.

### [ΔR Evaluation Criteria]

A: Less than 0.9 mΩ
B: 0.9 mΩ or greater, but less than 1.1 mΩ
C: 1.1 mΩ or greater

### (Examples 2 to 9 and Comparative Examples 1 to 2)

Crystalline solar battery module models were each produced in the same manner as in Example 1, provided that the average thickness of the electrically conductive layer of the tab wire, the average height of the fillet forming electrode, and the average distance between the tab wire and the fillet forming electrode were respectively changed to the average thickness of the electrically conductive layer of the tab wire, the average height of the fillet forming electrode, and the average distance between the tab wire and the fillet forming electrode, depicted in Table 1.

The produced crystalline solar battery module models were subjected to the same evaluations to those of Example 1. The results are presented in Table 1.

Note that, in Examples 1 to 9 and Comparative Example 2, the average height of the finger electrodes was 20 µm. In the case where the average height of the finger electrodes and the average height of the fillet forming electrodes were different, these height were adjusted by replacing a printing board of screen printing and overlapping the printing.

Each tab wire of all the crystalline solar battery models of Examples 1 to 9 had a wavy shape at the bonded area with the crystalline solar cell model.

In Comparative Example 1, moreover, a fillet forming electrode was not formed, and the average height of the finger electrodes was 20 µm.

**Table 1**

| | | Example | | | | | | | | | Comp. Ex. | |
|---|---|---|---|---|---|---|---|---|---|---|---|---|
| | | 1 | 2 | 3 | 4 | 5 | 6 | 7 | 8 | 9 | 1 | 2 |
| Average thickness of electrically conductive layer of tab wire (µm) | | 5 | 10 | 20 | 10 | 10 | 10 | 5 | 20 | 20 | 20 | 40 |
| Average height of electrode for forming fillet (µm) | | 20 | 20 | 20 | 20 | 20 | 20 | 10 | 40 | 60 | - | 20 |
| Average distance between tab wire and electrode for forming fillet (mm) | | 0 | 0 | 0 | 0.10 | 0.20 | 0.30 | 0.10 | 0 | 0 | - | 0 |
| Pealing strength (N/mm) | | 2.0 | 1.9 | 1.8 | 1.8 | 1.7 | 1.6 | 1.9 | 2.2 | 2.3 | 1.5 | 1.4 |
| Fillet forming state | | A | A | A | A | A | B | A | A | A | C | C |
| Over-all judgment | | A | A | A | A | A | B | A | A | A | C | C |
| Connection reliability | After TCT -initial (ΔR) | 0.4 | 0.5 | 0.7 | 0.6 | 0.7 | 1.0 | 0.5 | 0.4 | 0.3 | 1.1 | 1.2 |
| | Judgment | A | A | A | A | A | B | A | A | A | C | C |

In Comparative Example 1 where a fillet forming electrode was not formed, a fillet was not formed with the electrically conductive adhesive at the side surfaces of the tab wire, and the pealing strength was also insufficient.

Even in the case where a fillet forming electrode was formed, the pealing strength was not sufficient in Comparative Example 2 where a fillet covering the side surfaces of the tab wire was not formed.

In Comparative Examples 1 and 2, moreover, connection reliability was insufficient.

In the case where a fillet forming electrode was formed, the average weight of the fillet forming electrodes was equal to or greater than the average thickness of the electrically conductive layer of the tab wire, and the average distance between the tab wire and the fillet forming electrode was less than 0.30 mm (Examples 1 to 5 and Examples 7 to 9), on the other hand, the results of more excellent pealing strength and fillet formation state were obtained.

In Examples 1 to 9, moreover, the results of connection reliability were also excellent.

### Industrial Applicability

Since the crystalline solar battery module of the present invention excels in connection reliability, and adhesion between a tab wire and crystalline solar cells, the crystalline solar battery module of the present invention is suitably used for a crystalline solar battery module using crystalline solar cells of a busbar-less structure.

### Reference Signs List

- 1: crystalline solar battery module
- 2: crystalline solar cell
- 3: tab wire
- 3a: substrate
- 3b: electrically conductive layer
- 3c: electrically conductive layer
- 12: finger electrode
- 17: electrically conductive adhesive
- 17a: fillet
- 21: connection region
- 23: fillet forming electrode

## Claims

1. A crystalline solar battery module, comprising:
tab wires each containing an electrically conductive layer; and
crystalline solar cells each containing finger electrode,
wherein the electrically conductive layer and the finger electrodes are electrically connected with an electrically conductive adhesive,
wherein the crystalline solar cell has a busbar-less structure, in which no busbar electrode is present,
wherein the crystalline solar cell contains fillet forming electrodes, where the fillet forming electrodes are each formed to be at least partially in contact with or to be apart from side surfaces of the tab wires in connection regions, in each of which the crystalline solar cell and the tab wire are connected with the electrically conductive adhesive, and
wherein the electrically conductive adhesive forms fillets at least at part of the side surfaces of the tab wires.

2. The crystalline solar battery module according to claim 1, wherein an average height of the fillet forming electrodes is equal to or greater than an average thickness of the electrically conductive layer.

3. The crystalline solar battery module according to claim 1 or 2, wherein an average distance between the tab wire and the fillet forming electrode is 0 mm to 0.30 mm.

4. The crystalline solar battery module according to any one of claims 1 to 3, wherein an average thickness of the electrically conductive layer of the tab wire is 5 µm to 20 µm.

5. The crystalline solar battery module according to any one of claims 1 to 4, wherein an average height of the fillet forming electrodes is 10 µm to 60 µm.

6. The crystalline solar battery module according to any one of claims 1 to 5, wherein the tab wire has a wavy shape.

7. A production method of a crystalline solar battery module, comprising:
applying an electrically conductive adhesive onto light-receiving surfaces of a plurality of crystalline solar cells as well as opposite surfaces thereof to the light-receiving surfaces, arranging tab wires each containing an electrically conductive layer on the electrically conductive adhesive, and heating and pressing the tab wires, to thereby produce a string, in which finger electrodes of the crystalline solar cells are electrically connected with the tab wires with the electrically conductive adhesive, and the crystalline solar cells are connected in series;
covering the string with a sealing resin, and covering the sealing resin with a moisture barrier back sheet or a glass plate;
pressing the moisture barrier back sheet or the glass plate; and
heating a heating stage on which the string is placed,
wherein the crystalline solar cell has a busbar-less structure, in which no busbar electrode is present, and
wherein the arranging contains arranging the crystalline solar cells, the electrically conductive adhesive, and the tab wires in a manner that fillet forming electrodes of the crystalline solar cell are each at least partially in contact with or apart from side surfaces of the tab wires.

8. The production method according to claim 7, wherein an average height of the fillet forming electrodes is equal to or greater than an average thickness of the electrically conductive layer.
